# EUROPEAN PATENT APPLICATION

(11) **EP 4 391 760 A1**
(43) Date of publication of application: **26.06.2024**
(21) Application number: 23219085.0
(22) Date of filing: 21.12.2023
(51) Int. Cl.: H10B 12/00, G11C 11/403

(54) **MEMORY DEVICE INCLUDING VERTICAL CHANNEL TRANSISTOR AND ELECTRONIC DEVICE INCLUDING THE SAME**

(30) Priority: 23.12.2022 KR 20220183222
(71) Applicant: Samsung Electronics Co., Ltd., Suwon-si, Gyeonggi-do 16677 (KR)
(72) Inventor: KIM, Sangwook, 16678, Suwon-si, (KR); LEE, Kwanghee, 16678 Suwon-si, (KR); YANG, Jeeeun, 16678, Suwon-si, (KR); JUNG, Moonil, 16678, Suwon-si, (KR); KIM, Euntae, 16678, Suwon-si, (KR); CHA, Youngkwan, 16678, Suwon-si, (KR)
(74) Representative: Elkington and Fife LLP

(57) **Abstract**

A memory device includes a read word line on a substrate, a first channel extending along a plane perpendicular to an upper surface of the substrate, a second channel facing the first channel in parallel, a first gate insulation layer adjacent to the first channel between the first channel and the second channel, a second gate insulation layer adjacent to the second channel between the first channel and the second channel, a gate electrode adjacent to the first gate insulation layer between the first gate insulation layer and the second gate insulation layer, a write word line adjacent to the second gate insulation layer between the first gate insulation layer and the second gate insulation layer, a read bit line electrically connected to the first channel, and a write bit line electrically connected to the second channel.

## Description

### FIELD OF THE INVENTION

The inventive concepts relate to memory devices including a vertical channel transistor, and electronic devices including the same.

### BACKGROUND OF THE INVENTION

A unit memory cell of a typical dynamic random access memory (DRAM) device includes one transistor and one capacitor (1T1C) and may store information by charging or discharging electric charges in or from the capacitor. In such a 1T1C structure, a transistor and a capacitor which have different structures are formed, and thus, the manufacturing process thereof may be complicated. In addition, when the degree of integration of memory increases, there is a problem in that capacitance decreases as the area of the capacitor decreases. Accordingly, various memory cells that have no capacitor have been proposed.

For example, a 2T-memory cell includes two transistors, that is, a read transistor and a write transistor, and may store information in a parasitic capacitor formed at a node between the read transistor and the write transistor. However, it is difficult to increase the degree of integration of the 2T-memory cell due to the increased number of wires compared to the 1T1C structure and due to the space thereof occupied by two transistors. When two transistors are stacked on different layers to increase the degree of integration, the manufacturing process may be complicated.

### SUMMARY OF THE INVENTION

Some example embodiments of the inventive concepts provide a memory device having a higher degree of integration without requiring a complicated manufacturing process. Some example embodiments of the inventive concepts provide an electronic device including the memory device.

Some example embodiments of the inventive concepts provide a memory device having a small leakage current. Some example embodiments of the inventive concepts provide an electronic device including the memory device.

Additional aspects will be set forth in part in the description which follows and, in part, will be apparent from the description, or may be learned by practice of the presented embodiments of the inventive concepts.

According to some example embodiments of the inventive concepts, a memory device includes a substrate, a read word line on the substrate, a first channel electrically connected to the read word line and extending along a plane perpendicular to an upper surface of the substrate, a second channel facing the first channel in parallel, a first gate insulation layer adjacent to the first channel between the first channel and the second channel, a second gate insulation layer adjacent to the second channel between the first channel and the second channel, a gate electrode adjacent to the first gate insulation layer between the first gate insulation layer and the second gate insulation layer, a write word line adjacent to the second gate insulation layer between the first gate insulation layer and the second gate insulation layer, a read bit line electrically connected to the first channel, and a write bit line electrically connected to the second channel.

The first channel, the second channel, the first gate insulation layer, the second gate insulation layer, the gate electrode, and the write word line may have a shape protruding in a direction perpendicular to the upper surface of the substrate.

The read word line may be on the substrate such that a lower surface and opposite side surfaces of the read word line are surrounded by the substrate, the read word line extending in a first direction parallel to the upper surface of the substrate.

The first channel, the second channel, the read bit line, the first gate insulation layer, the gate electrode, the second gate insulation layer, the write word line, and the write bit line may extend in a second direction perpendicular to the first direction and parallel to the upper surface of the substrate.

The first gate insulation layer may include a main body portion extending in a direction perpendicular to the upper surface of the substrate and an extension portion extending from a lower portion of the main body portion of the first gate insulation layer in a separate direction parallel to the upper surface of the substrate.

The main body portion of the first gate insulation layer may be between the first channel and the gate electrode, and the extension portion of the first gate insulation layer may be between a lower surface of the second channel and the read word line.

The lower surface of the second channel may be in contact with an upper surface of the extension portion of the first gate insulation layer, and an upper surface of the second channel may be electrically connected to the write bit line.

The gate electrode may include a main body portion extending in the direction perpendicular to the upper surface of the substrate and an extension portion extending from a lower portion of the main body portion of the gate electrode in the separate direction parallel to the upper surface of the substrate.

The extension portion of the gate electrode may be on the upper surface of the extension portion of the first gate insulation layer and contact a lower side surface of the second channel.

The second gate insulation layer may include a main body portion extending in the direction perpendicular to the upper surface of the substrate, a first extension portion extending from a lower portion of the main body portion of the second gate insulation layer in the separate direction parallel to the upper surface of the substrate, and a second extension portion extending from the first extension portion and in the direction perpendicular to the upper surface of the substrate.

The first extension portion of the second gate insulation layer may be on an upper surface of the extension portion of the gate electrode, and the second extension portion of the second gate insulation layer may be in contact with the main body portion of the gate electrode.

A first side surface of the write word line may be in contact with the main body portion of the second gate insulation layer, a lower surface of the write word line may be in contact with the first extension portion of the second gate insulation layer, and a second side surface of the write word line opposite the first side surface may be in contact with the second extension portion of the second gate insulation layer.

A lower surface of the first channel may contact the read word line, and an upper surface of the first channel may contact the read bit line.

The first channel, the first gate insulation layer, and the gate electrode may collectively define a read transistor, and the second channel, the second gate insulation layer, and the write word line may collectively define a write transistor.

The first channel and the second channel may each include an oxide semiconductor material, and the read transistor and the write transistor may each include a separate oxide semiconductor transistor.

According to some example embodiments of the inventive concepts, a memory device includes a plurality of memory cells extending two-dimensionally in a plurality of rows and a plurality of columns, a plurality of read word lines extending along a first direction and connected to separate, respective columns of memory cells of the plurality of memory cells, a plurality of read bit lines extending along a second direction perpendicular to the first direction and connected to separate, respective rows of memory cells of the plurality of memory cells, a plurality of write word lines extending along the second direction and connected to separate, respective rows of memory cells of the plurality of memory cells, and a plurality of write bit lines extending along the second direction and connected to separate, respective rows of memory cells of the plurality of memory cells, wherein each memory cell of the plurality of memory cells may include a substrate, a first channel extending along a plane perpendicular to an upper surface of the substrate, a second channel facing the first channel in parallel, a first gate insulation layer adjacent to the first channel between the first channel and the second channel, a second gate insulation layer adjacent to the second channel between the first channel and the second channel, and a gate electrode adjacent to the first gate insulation layer between the first gate insulation layer and the second gate insulation layer.

Each read word line of the plurality of read word lines may be on the substrate such that a lower surface and opposite side surfaces of the read word line are surrounded by the substrate.

The first channel may be electrically connected to one read word line of the plurality of read word lines and one read bit line of the plurality of read bit lines, the second channel may be electrically connected to one write bit line of the plurality of write bit lines, and one of the plurality of write word lines may be adjacent to the second gate insulation layer between the first gate insulation layer and the second gate insulation layer.

The plurality of memory cells may include a first memory cell and a second memory cell adjacent to each other in the first direction, wherein the first memory cell and the second memory cell have a mirror symmetry across a plane of symmetry that extends perpendicular to the first direction.

According to some example embodiments of the inventive concepts, an electronic device may include a memory device and a memory controller configured to control the memory device to read data from the memory device or write data to the memory device, wherein the memory device may include a substrate, a read word line on the substrate, a first channel electrically connected to the read word line and extending along a plane perpendicular to an upper surface of the substrate, a second channel facing the first channel in parallel, a first gate insulation layer adjacent to the first channel between the first channel and the second channel, a second gate insulation layer adjacent to the second channel between the first channel and the second channel, a gate electrode adjacent to the first gate insulation layer between the first gate insulation layer and the second gate insulation layer, a write word line adjacent to the second gate insulation layer between the first gate insulation layer and the second gate insulation layer, a read bit line electrically connected to the first channel, and a write bit line electrically connected to the second channel.

### BRIEF DESCRIPTION OF THE DRAWINGS

The above and other aspects, features, and advantages of certain embodiments of the inventive concepts will be more apparent from the following description taken in conjunction with the accompanying drawings, in which:
FIG. 1 is a schematic cross-sectional view of a structure of a memory cell of a memory device according to some example embodiments;
FIGS. 2, 3, 4, and 5 are schematic cross-sectional views of a cross-sectional structure of the memory cell illustrated in FIG. 1, from various locations;
FIG. 6 is an example of an equivalent circuit diagram of the memory cell of FIG. 1;
FIGS. 7A, 7B, 7C, 7D, 7E, 7F, 7G, 7H, 7I, 7J, 7K, 7L, 7M, 7N, and 7O are schematic cross-sectional views of a manufacturing process of the memory cell of the memory device illustrated in FIG. 1;
FIG. 8 is a schematic cross-sectional view of an arrangement of a plurality of memory cells of a memory device;
FIG. 9 is a schematic block diagram of an electronic system including a memory device;
FIG. 10 is a schematic block diagram of another electronic system including a memory device;
FIG. 11 is a schematic block diagram of a neuromorphic apparatus including a memory device; and
FIG. 12 is a flowchart showing a method according to some example embodiments.

### DETAILED DESCRIPTION

Reference will now be made in detail to example embodiments, some of which are illustrated in the accompanying drawings, wherein like reference numerals refer to like elements throughout. In this regard, some example embodiments may have different forms and should not be construed as being limited to the descriptions set forth herein. Accordingly, some example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, a memory device including a vertical channel transistor will be described in detail with reference to the attached drawings. In the drawings, like reference numerals refer to like elements throughout and sizes of constituent elements may be exaggerated for convenience of explanation and the clarity of the specification. Also, embodiments described herein may have different forms and should not be construed as being limited to the descriptions set forth herein.

It will also be understood that when an element is referred to as being "on" or "above" another element, the element may be in direct contact with the other element or other intervening elements may be present. The singular forms include the plural forms unless the context clearly indicates otherwise. It should be understood that, when a part "comprises" or "includes" an element, unless otherwise defined, other elements are not excluded from the part and the part may further include other elements.

Hereinafter, the terms "above" or "on" may include not only those that are directly on in a contact manner, but also those that are above in a non-contact manner. The singular forms "a," "an," and "the" as used herein are intended to include the plural forms as well unless the context clearly indicates otherwise. It will be understood that the terms "comprise," "include," or "have" as used herein specify the presence of stated elements, but do not preclude the presence or addition of one or more other elements.

The use of the term "the" and similar demonstratives may correspond to both the singular and the plural. Operations constituting methods may be performed in any suitable order unless otherwise indicated herein or otherwise clearly contradicted by context, and are not necessarily limited to the stated order.

The use of all illustrations or illustrative terms in some example embodiments is simply to describe the technical ideas in detail, and the scope of the present inventive concepts is not limited by the illustrations or illustrative terms unless they are limited by claims.

It will be understood that elements and/or properties thereof (e.g., structures, surfaces, directions, or the like), which may be referred to as being "perpendicular," "parallel," "coplanar," or the like with regard to other elements and/or properties thereof (e.g., structures, surfaces, directions, or the like) may be "perpendicular," "parallel," "coplanar," or the like or may be "substantially perpendicular," "substantially parallel," "substantially coplanar," respectively, with regard to the other elements and/or properties thereof.

Elements and/or properties thereof (e.g., structures, surfaces, directions, or the like) that are "substantially perpendicular" with regard to other elements and/or properties thereof will be understood to be "perpendicular" with regard to the other elements and/or properties thereof within manufacturing tolerances and/or material tolerances and/or have a deviation in magnitude and/or angle from "perpendicular," or the like with regard to the other elements and/or properties thereof that is equal to or less than 10% (e.g., a. tolerance of ±10%).

Elements and/or properties thereof (e.g., structures, surfaces, directions, or the like) that are "substantially parallel" with regard to other elements and/or properties thereof will be understood to be "parallel" with regard to the other elements and/or properties thereof within manufacturing tolerances and/or material tolerances and/or have a deviation in magnitude and/or angle from "parallel," or the like with regard to the other elements and/or properties thereof that is equal to or less than 10% (e.g., a. tolerance of ±10%).

Elements and/or properties thereof (e.g., structures, surfaces, directions, or the like) that are "substantially coplanar" with regard to other elements and/or properties thereof will be understood to be "coplanar" with regard to the other elements and/or properties thereof within manufacturing tolerances and/or material tolerances and/or have a deviation in magnitude and/or angle from "coplanar," or the like with regard to the other elements and/or properties thereof that is equal to or less than 10% (e.g., a. tolerance of ±10%)).

It will be understood that elements and/or properties thereof may be recited herein as being "the same" or "equal" as other elements, and it will be further understood that elements and/or properties thereof recited herein as being "identical" to, "the same" as, or "equal" to other elements may be "identical" to, "the same" as, or "equal" to or "substantially identical" to, "substantially the same" as or "substantially equal" to the other elements and/or properties thereof. Elements and/or properties thereof that are "substantially identical" to, "substantially the same" as or "substantially equal" to other elements and/or properties thereof will be understood to include elements and/or properties thereof that are identical to, the same as, or equal to the other elements and/or properties thereof within manufacturing tolerances and/or material tolerances. Elements and/or properties thereof that are identical or substantially identical to and/or the same or substantially the same as other elements and/or properties thereof may be structurally the same or substantially the same, functionally the same or substantially the same, and/or compositionally the same or substantially the same.

It will be understood that elements and/or properties thereof described herein as being "substantially" the same and/or identical encompasses elements and/or properties thereof that have a relative difference in magnitude that is equal to or less than 10%. Further, regardless of whether elements and/or properties thereof are modified as "substantially," it will be understood that these elements and/or properties thereof should be construed as including a manufacturing or operational tolerance (e.g., ±10%) around the stated elements and/or properties thereof.

When the terms "about" or "substantially" are used in this specification in connection with a numerical value, it is intended that the associated numerical value include a tolerance of ±10% around the stated numerical value. When ranges are specified, the range includes all values therebetween such as increments of 0.1%.

While the term "same," "equal" or "identical" may be used in description of some example embodiments, it should be understood that some imprecisions may exist. Thus, when one element is referred to as being the same as another element, it should be understood that an element or a value is the same as another element within a desired manufacturing or operational tolerance range (e.g., ±10%).

When the terms "about" or "substantially" are used in this specification in connection with a numerical value, it is intended that the associated numerical value includes a manufacturing or operational tolerance (e.g., ±10%) around the stated numerical value. Moreover, when the words "about" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

As described herein, when an operation is described to be performed, or an effect such as a structure is described to be established "by" or "through" performing additional operations, it will be understood that the operation may be performed and/or the effect/structure may be established "based on" the additional operations, which may include performing said additional operations alone or in combination with other further additional operations.

As described herein, an element that is described to be "spaced apart" from another element, in general and/or in a particular direction (e.g., vertically spaced apart, laterally spaced apart, etc.) and/or described to be "separated from" the other element, may be understood to be isolated from direct contact with the other element, in general and/or in the particular direction (e.g., isolated from direct contact with the other element in a vertical direction, isolated from direct contact with the other element in a lateral or horizontal direction, etc.). Similarly, elements that are described to be "spaced apart" from each other, in general and/or in a particular direction (e.g., vertically spaced apart, laterally spaced apart, etc.) and/or are described to be "separated" from each other, may be understood to be isolated from direct contact with each other, in general and/or in the particular direction (e.g., isolated from direct contact with each other in a vertical direction, isolated from direct contact with each other in a lateral or horizontal direction, etc.). Similarly, a structure described herein to be between two other structures to separate the two other structures from each other may be understood to be configured to isolate the two other structures from direct contact with each other.

The use of the terms "a" and "an" and "the" and similar referents are to be construed to cover both the singular and the plural. The steps of all methods described herein can be performed in any suitable order unless otherwise indicated herein or otherwise clearly contradicted by context, and are not limited to the described order.

Also, in the specification, the term "... units" or "...modules" denote units or modules that process at least one function or operation, and may be realized by hardware, software, or a combination of hardware and software.

Furthermore, the connecting lines, or connectors illustrated in the various figures presented are intended to represent example functional relationships and/or physical or logical couplings between the various elements. It should be noted that many alternative or additional functional relationships, physical connections or logical connections may be present in a practical device.

The use of any and all examples, or example language (e.g., "such as") provided herein, is intended merely to better illuminate the inventive concepts and does not pose a limitation on the scope of the inventive concepts unless otherwise claimed.

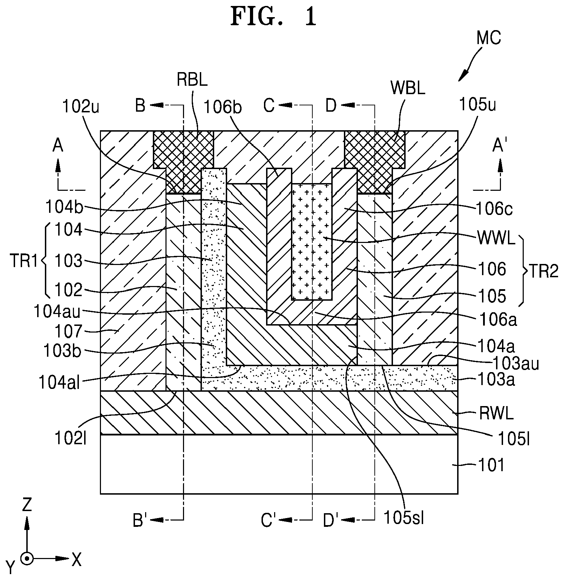

FIG. 1 is a schematic cross-sectional view of a structure of a memory cell of a memory device according to some example embodiments. Referring to FIG. 1, one memory cell MC of the memory device may include a read word line RWL on a substrate 101, a first channel 102 electrically connected to the read word line RWL, a second channel 105 disposed to face the first channel 102, a first gate insulation layer 103 disposed adjacent to the first channel 102 between the first channel 102 and the second channel 105, a second gate insulation layer 106 disposed adjacent to the second channel 105 between the first channel 102 and the second channel 105, a gate electrode 104 disposed adjacent to the first gate insulation layer 103 between the first gate insulation layer 103 and the second gate insulation layer 106, and a write word line WWL disposed adjacent to the second gate insulation layer 106 between the first gate insulation layer 103 and the second gate insulation layer 106. It will be understood that an element that is adjacent to another element may be in contact with the other element, such that opposing surface of the element and the adjacent other element are in contact with each other.

In addition, the memory cell MC may further include a read bit line RBL electrically connected to the first channel 102 and a write bit line WBL electrically connected to the second channel 105. In addition, the memory cell MC may further include a passivation layer 107 arranged to cover a side surface of the first channel 102, a side surface (e.g., opposite side surface) of the second channel 105, an upper surface of the first gate insulation layer 103, an upper surface of the second gate insulation layer 106, an upper surface of the gate electrode 104, an upper surface of the write word line WWL, a side surface of the read bit line RBL, and a side surface of the write bit line WBL.

The first channel 102 and the second channel 105 that faces the first channel 102 in parallel may extend in parallel to each other along a plane perpendicular to the upper surface 101u of the substrate 101. For example, when the upper surface of the substrate 101 is disposed along (e.g., extends along and/or defines a portion of) a XY plane, the first channel 102 and the second channel 105 may extend along an YZ plane. In other words, dimensions of the first channel 102 and the second channel 105 along a first direction (i.e., a X-direction) may be less (e.g., smaller) than dimensions thereof along a second direction (i.e., a Y-direction) perpendicular to the first direction and dimensions thereof along a third direction perpendicular to the first and second directions (i.e., a Z-direction). Accordingly, the first channel 102 and the second channel 105 may protrude in a direction perpendicular to the upper surface 101u of the substrate 101 (e.g., the Z-direction).

In addition, the first gate insulation layer 103, the second gate insulation layer 106, the gate electrode 104, and the write word line WWL may also extend along a plane perpendicular to the upper surface 101u of the substrate 101. In other words, the first gate insulation layer 103, the second gate insulation layer 106, the gate electrode 104, and the write word line WWL may protrude in a direction perpendicular to the upper surface 101u of the substrate 101. Thus, main surfaces of the first channel 102, the second channel 105, the first gate insulation layer 103, the second gate insulation layer 106, the gate electrode 104, and the write word line WWL may be arranged in parallel to each other along a direction perpendicular to the upper surface 101u of the substrate 101 (e.g., the Z-direction).

A lower surface 1021 of the first channel 102 may contact and be electrically connected to the read word line RWL. Also, an upper surface 102u of the first channel 102 may contact and be electrically connected to the read bit line RBL. Accordingly, both ends (e.g., opposite ends, defining lower and upper surfaces 102l and 102u) of the first channel 102 may be electrically connected to the read word line RWL and the read bit line RBL.

The first gate insulation layer 103 may include a main body portion 103b extending in a direction perpendicular to the upper surface 101u of the substrate 101 (e.g., the Z-direction) and an extension portion 103a extending from a lower portion of the main body portion 103b in a direction (e.g., a separate direction) parallel to the upper surface 101u of the substrate 101 (e.g., the X-direction). Accordingly, the first gate insulation layer 103 as a whole may have a shape bent at about 90 degrees (e.g., an L-shape). The extension portion 103a of the first gate insulation layer 103 may be disposed between (e.g., directly between) a lower surface 105l of the second channel 105 and the read word line RWL and thus may reduce, minimize, or prevent electrical connection between the second channel 105 and the read word line RWL, such that the second channel 105 and the read word line RWL may be electrically insulated from each other by at least the first gate insulation layer 103. In addition, the main body portion 103b of the first gate insulation layer 103 may be disposed between the first channel 102 and the gate electrode 104 and thus prevent electrical connection between the first channel 102 and the gate electrode 104.

The lower surface of the second channel 105 does not contact (e.g., is isolated from direct contact with) the read word line RWL. To this end, the lower surface 105l of the second channel 105 may be disposed in contact with an upper surface 103au of the extension portion 103a of the first gate insulation layer 103. Also, the upper surface 105u of the second channel 105 may be electrically connected to the write bit line WBL.

The gate electrode 104 may include a main body portion 104b extending along a direction perpendicular to the upper surface 101u of the substrate 101 (e.g., the Z-direction) and an extension portion 104a extending from a lower portion of the main body portion 104b and in a direction (e.g., a separate direction) parallel to the upper surface 101u of the substrate 101. Accordingly, the gate electrode 104 may have a shape bent at about 90 degrees (e.g., an L-shape). The extension portion 104a of the gate electrode 104 may be disposed on the upper surface 103au of the extension portion 103a of the first gate insulation layer 103 and may contact a lower side surface 105sl of the second channel 105 which is adjacent to the lower surface 105l of the second channel 105. The gate electrode 104 and the second channel 105 may be electrically connected through the extension portion 104a of the gate electrode 104. Accordingly, both ends of the second channel 105 may be electrically connected to the gate electrode 104 and the write bit line WBL, respectively.

The second gate insulation layer 106 may include a main body portion 106c extending in a direction perpendicular to the upper surface 101u of the substrate 101 (e.g., the Z-direction), a first extension portion 106a extending from a lower portion of the main body portion 106c in a direction (e.g., a separate direction) parallel to the upper surface 101u of the substrate 101 (e.g., the X-direction), and a second extension portion 106b extending from the first extension portion 106a in a direction perpendicular to the upper surface 101u of the substrate 101 (e.g., the Z-direction). For example, the first extension portion 106a may extend between respective lower portions of the main body portion 106c and the second extension portion 106b. Accordingly, the second gate insulation layer 106 may have a shape bent in an approximate 'U' shape. The first extension portion 106a of the second gate insulation layer 106 may be disposed on an upper surface 104au of the extension portion 104a of the gate electrode 104. The second extension portion 106b of the second gate insulation layer 106 may be disposed in contact with the main body portion 104b of the gate electrode 104.

Three surfaces of the write word line WWL may be surrounded by the second gate insulation layer 106. For example, as shown in FIG. 1, a first side surface of the write word line WWL may contact the main body portion 106c of the second gate insulation layer 106, a lower surface of the write word line WWL may contact the first extension portion 106a of the second gate insulation layer 106, and a second side surface of the write word line WWL, opposite to the first side surface of the write word line WWL, may contact the second extension portion 106b of the second gate insulation layer 106. Thus, the first extension portion 106a and the second extension portion 106b of the second gate insulation layer 106 may be disposed between the write word line WWL and the gate electrode 104 to reduce, minimize, or prevent electrical contact between the write word line WWL and the gate electrode 104, such that the write word line WWL and the gate electrode 104 may be electrically insulated from each other by at least the second gate insulating layer 106. In addition, the main body portion 106c of the second gate insulation layer 106 may be disposed between the write word line WWL and the second channel 105 to reduce, minimize or prevent electrical contact between the write word line WWL and the second channel 105 such that the write word line WWL and the second channel 105 may be electrically insulated from each other by at least the second gate insulating layer 106. As shown, the lower surface 104al of the main body portion 104b of the gate electrode 104 and the lower surface 105l of the second channel 105 may both be on the upper surface 103au of the extension portion 103a and may be coplanar with each other.

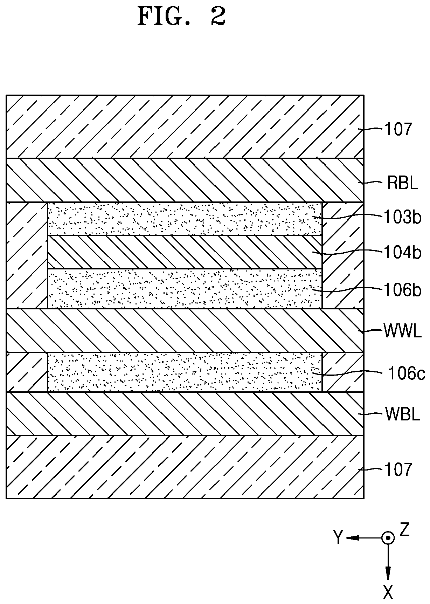

FIGS. 2, 3, 4, and 5 are schematic cross-sectional views of a cross-sectional structure of the memory cell MC illustrated in FIG. 1, from various locations.

First, FIG. 2 illustrates an example of a horizontal cross-section of the memory cell MC illustrated in FIG. 1 taken along line A-A'. Referring to FIG. 2, the read bit line RBL, the main body portion 103b of the first gate insulation layer 103, the main body portion 104b of the gate electrode 104, the second extension portion 106b of the second gate insulation layer 106, the write word line WWL, the main body portion 106c of the second gate insulation layer 106, and the write bit line WBL may be sequentially disposed in the first direction (i.e., X-direction) which may parallel to the upper surface 101u of the substrate 101. The read word line RWL may extend in the first direction (e.g., the X-direction). The first channel 102 may be disposed below the read bit line RBL and the second channel 105 may be disposed below the write bit line WBL. When viewed from a horizontal cross-section, the read bit line RBL, the first gate insulation layer 103, the gate electrode 104, the second gate insulation layer 106, the write word line WWL, and the write bit line WBL may all extend (e.g., may extend in parallel with each other) in the second direction (i.e., the Y-direction) which may be perpendicular to the first direction and parallel to the upper surface 101u of the substrate 101. Although not illustrated in FIG. 2, the first channel 102 and the second channel 105 may also extend in the second direction (i.e., the Y-direction). The read bit line RBL, the write word line WWL, and the write bit line WBL may be arranged in parallel to each other (e.g., may extend in parallel with each other in the Y-direction). In addition, dimensions of the read bit line RBL, the write word line WWL, and the write bit line WBL in the second direction (e.g., Y-direction) may be greater than those of the first gate insulation layer 103, the gate electrode 104, and the second gate insulation layer 106 in the second direction (e.g., Y-direction).

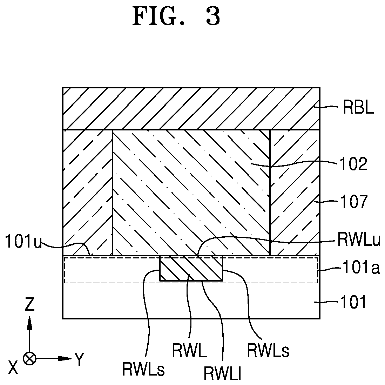

FIG. 3 illustrates an example of a vertical cross-section of the memory cell MC illustrated in FIG. 1 taken along line B-B'. Referring to FIG. 3, the read word line RWL may be disposed inside an upper portion 101a of the substrate 101. For example, the read word line RWL may be disposed such that a lower surface RWLI and both side surfaces (e.g., opposite side surfaces RWLs) of the read word line RWL are surrounded by (e.g., in contact with respective surfaces of) the substrate 101. An upper surface RWLu of the read word line RWL and the upper surface 101u of the substrate 101 may be on the same plane (e.g., may be coplanar). In other words, there may be no step between the upper surface RWLu of the read word line RWL and the upper surface 101u of the substrate 101. Also, the read word line RWL may be elongated along the first direction (i.e., the X-direction). Accordingly, the read word line RWL may be arranged in a direction perpendicular to other lines, for example, the read bit line RBL, the write word line WWL, and the write bit line WBL.

The first channel 102 may be disposed on the substrate 101 and the read word line RWL. The read bit line RBL may be disposed on the first channel 102. The first channel 102 and the read bit line RBL may extend along the second direction. A dimension of the read bit line RBL in the second direction (e.g., the Y direction) may be greater than that of the first channel 102 in the second direction. Also, a dimension of the first channel 102 in the second direction may be greater than that of the read word line RWL in the second direction. The passivation layer 107 may be filled in a space between the first channel 102 and the read bit line RBL.

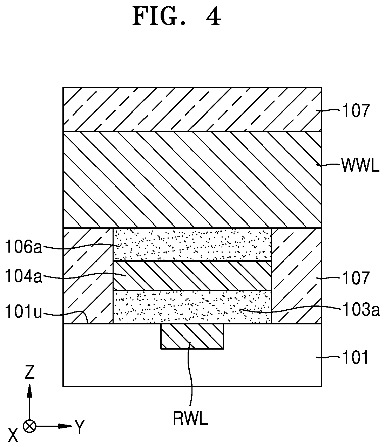

FIG. 4 illustrates an example of a vertical cross-section of the memory cell MC illustrated in FIG. 1 taken along line C-C'. Referring to FIG. 4, the extension portion 103a of the first gate insulation layer 103, the extension portion 104a of the gate electrode 104, and the first extension portion 106a of the second gate insulation layer 106 may be sequentially disposed on the substrate 101 and the read word line RWL along the third direction, also referred to herein as a vertical direction (i.e., the Z-direction). The write word line WWL may be disposed on the first extension portion 106a of the second gate insulation layer 106. In addition, the passivation layer 107 may be disposed to cover side surfaces (e.g., opposite side surfaces in the Y-direction) of each of the extension portion 103a of the first gate insulation layer 103, the extension portion 104a of the gate electrode 104, and the first extension portion 106a of the second gate insulation layer 106 and the upper surface of the write word line WWL. Dimensions of the extension portion 103a of the first gate insulation layer 103, the extension portion 104a of the gate electrode 104, and the first extension portion 106a of the second gate insulation layer 106 in the second direction may be equal to each other, may be greater than those of the read word line RWL in the second direction, and may be less than those of the write word line WWL in the second direction.

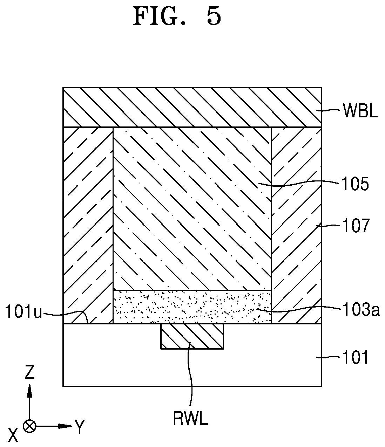

FIG. 5 illustrates an example of a vertical cross-section of the memory cell MC illustrated in FIG. 1 taken along line D-D'. Referring to FIG. 5, the extension portion 103a of the first gate insulation layer 103 may be disposed on the substrate 101 and the read word line RWL. The second channel 105 may be disposed on the extension portion 103a of the first gate insulation layer 103. The write bit line WBL may be disposed on the second channel 105. The passivation layer 107 may be disposed to cover side surfaces (e.g., opposite side surfaces in the Y-direction) of the extension portion 103a of the first gate insulation layer 103 and side surfaces (e.g., opposite side surfaces in the Y-direction) of the second channel 105. Dimensions of the extension portion 103a of the first gate insulation layer 103 and the second channel 105 in the second direction may be equal to each other, may be greater than those of the read word line RWL in the second direction, and may be less than those of the write bit line WBL in the second direction.

Referring back to FIG. 1, the first channel 102, the first gate insulation layer 103, and the gate electrode 104 may form (e.g., may collectively define) a read transistor TR1. In particular, the first channel 102, the main body portion 103b of the first gate insulation layer 103, and the main body portion 104b of the gate electrode 104 may form (e.g., may collectively define) the read transistor TR1. In other words, the read transistor TR1 may include the first channel 102, the main body portion 103b of the first gate insulation layer 103, and the main body portion 104b of the gate electrode 104.

Also, the second channel 105, the second gate insulation layer 106, and the write word line WWL may form (e.g., may collectively define) a write transistor TR2. In particular, the second channel 105, the main body portion 106c of the second gate insulation layer 106, and the write word line WWL may form (e.g., may collectively define) the write transistor TR2. In other words, the write transistor TR2 may include the second channel 105, the main body portion 106c of the second gate insulation layer 106, and the write word line WWL. The write word line WWL acting (e.g., configured to act) as a write word line may also act (e.g., may also be configured to act) as a gate electrode of the write transistor TR2.

The read transistor TR1 and the write transistor TR2 may be vertical channel transistors having a channel perpendicular to the upper surface 101u of the substrate 101. According to some example embodiments, as main components forming the read transistor TR1 and the write transistor TR2 are arranged in parallel to each other in a direction perpendicular to the substrate 101 (e.g., in the Z-direction), the respective and collective areas of the read transistor TR1 and the write transistor TR2 on the upper surface 101u of the substrate 101 along the XY plane may be reduced. Accordingly, the degree of integration of the memory cells MC in the memory device may be improved. In addition, since the memory cells MC of the memory device according to some example embodiments may mitigate, reduce, or minimize the quantity of layers stacked on the substrate 101 in a direction perpendicular to the substrate 101, the manufacturing process to manufacture the memory device may be simplified, reduced in complexity, or the like, thereby enabling improvement in manufacturing efficiency and thereby reducing cost of manufacture of the memory device.

The read transistor TR1 and the write transistor TR2 may each include and/or may each be separate oxide semiconductor transistors using an oxide semiconductor as a channel. For example, the first channel 102 and the second channel 105 may each include an oxide of at least one of indium (In), zinc (Zn), tin (Sn), gallium (Ga), hafnium (Hf), cadmium (Cd), or germanium (Ge). The first channel 102 and the second channel 105 may include, for example, at least one oxide semiconductor material selected from among zinc indium oxide (ZIO), indium gallium oxide (IGO), or indium gallium zinc oxide (IGZO).

The read word line RWL, the read bit line RBL, the write word line WWL, the write bit line WBL, and the gate electrode 104 may include a metal or metal alloy having conductivity. For example, the read word line RWL, the read bit line RBL, the write word line WWL, the write bit line WBL, and the gate electrode 104 may include at least one metal selected from among tungsten (W), cobalt (Co), nickel (Ni), iron (Fe), titanium (Ti), molybdenum (Mo), chromium (Cr), zirconium (Zr), hafnium (Hf), niobium (Nb), tantalum (Ta), silver (Ag), gold (Au), aluminum (Al), copper (Cu), antimony (Sb), vanadium (V), ruthenium (Ru), platinum (Pt), zinc (Zn), and magnesium (Mg), or a metal alloy thereof.

Source/drain regions of the read transistor TR1 may be formed at interfaces between the first channel 102 including an oxide semiconductor material and the read word line RWL and the read bit line RBL which include a metal material. In addition, source/drain regions of the write transistor TR2 may be formed at an interface between the second channel 105 and the extension portion 104a of the gate electrode 104 and at an interface between the second channel 105 and the write bit line WBL. Accordingly, the structures of the read transistor TR1 and the write transistor TR2 may be simplified since there is no need to form separate source and drain regions.

When oxide semiconductor transistors are used as the read transistor TR1 and the write transistor TR2, gate induced drain leakage (GIDL) current and source-drain tunneling (SD tunneling) are relatively small, and thus leakage current may be as low as 10⁻¹⁸ A/cm or less. Thus, information may be stably stored only with parasitic capacitance near the gate electrode 104 without a separate capacitor, thereby improving operational performance and/or efficiency of a memory device including memory cells MC having oxide semiconductor transistors used as the read transistor TR1 and the write transistor TR2.

However, the first channel 102 and the second channel 105 do not have to necessarily include an oxide semiconductor and may include various other semiconductor materials. The first channel 102 and the second channel 105 may include, for example, silicon, a Group III-V compound semiconductor, or transition metal dichalcogenide. The transition metal dichalcogenide may include, for example, MoS₂, WS₂, MoSe₂, WSe₂, MoTe₂, or the like.

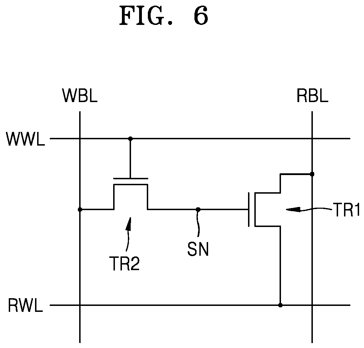

FIG. 6 is an example of an equivalent circuit diagram of the memory cell MC illustrated in FIG. 1. Referring to FIG. 6, the memory cell MC may include the read transistor TR1, the write transistor TR2, the write word line WWL connected to a gate electrode of the write transistor TR2, the write bit line WBL connected to a first end of a channel of the write transistor TR2, the read bit line RBL connected to a first end of a channel of the read transistor TR1, and the read word line RWL connected to a second end of the channel of the read transistor TR1. A gate electrode of the read transistor TR1 may be connected to a second end of the channel of the write transistor TR2. Also, the write word line WWL may be the gate electrode itself of the write transistor TR2. FIG. 6 illustrates that the read bit line RBL and the write bit line WBL are parallel to each other, and the read word line RWL and the write word line WWL are parallel to each other, but this is merely for convenience of illustration of the circuit diagram, and may differ from the actual arrangement direction.

In this structure, when a voltage greater than a threshold voltage of the write transistor TR2 is applied to the write word line WWL, and a high voltage is applied to the write bit line WBL, charges may be filled in a storage node SN between the write transistor TR2 and the read transistor TR1. The storage node SN may be, for example, a parasitic capacitor formed around the gate electrode 104 in FIG. 1. Then, when a voltage greater than the threshold voltage of the write transistor TR2 is applied to the write word line WWL and a low voltage is applied to the write bit line WBL, charges may be discharged from the storage node SN between the write transistor TR2 and the read transistor TR1. Also, information stored in the storage node SN may be read from a current flowing between the read word line RWL and the read bit line RBL.

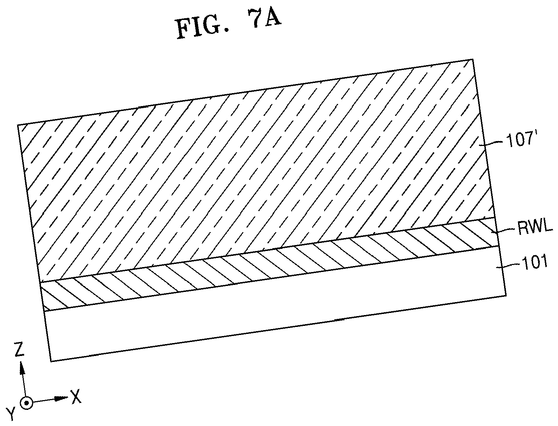

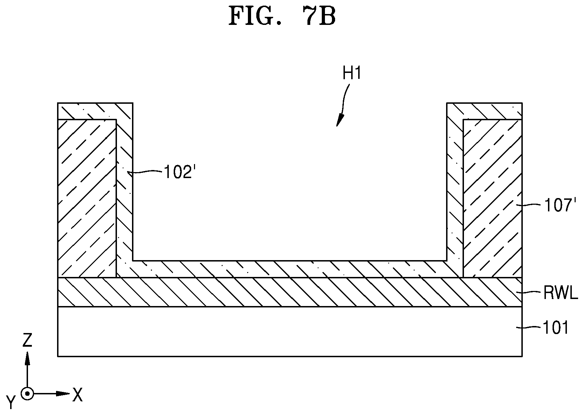

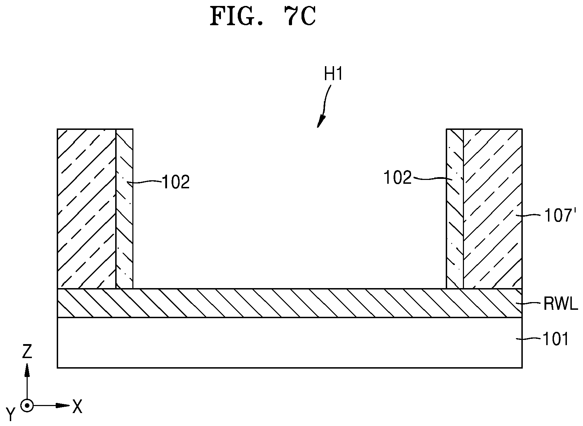

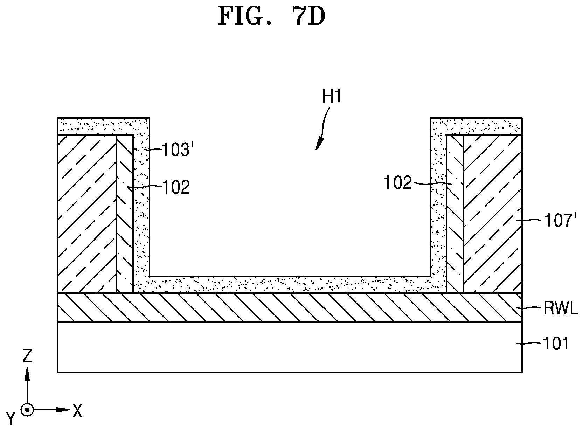

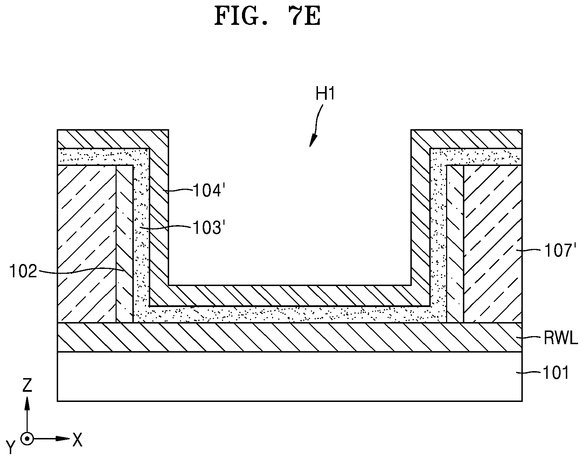

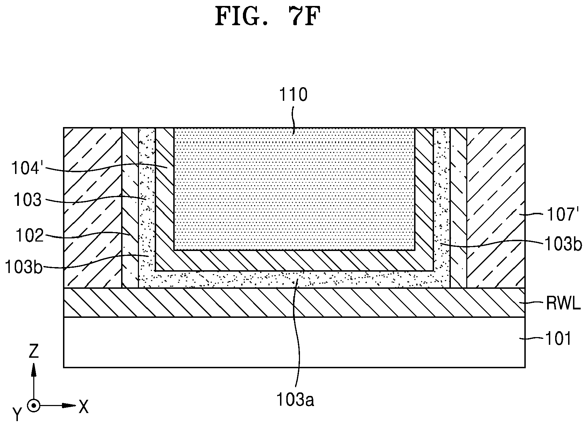

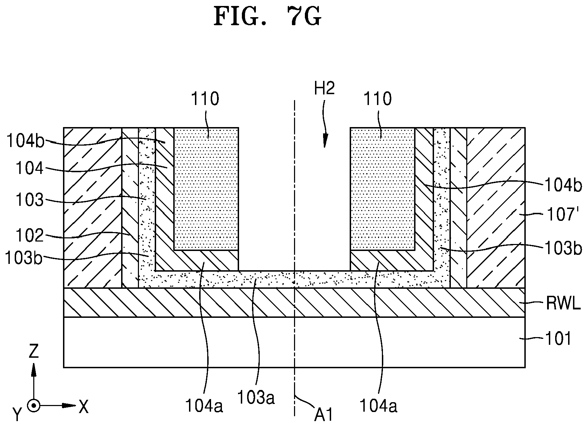

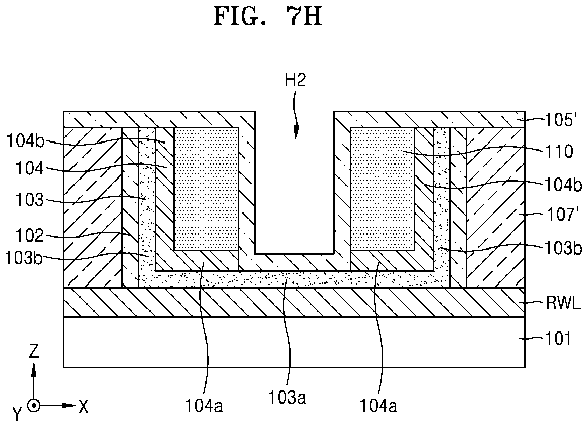

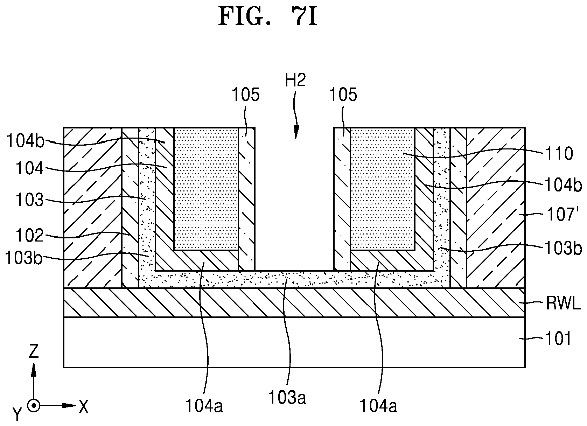

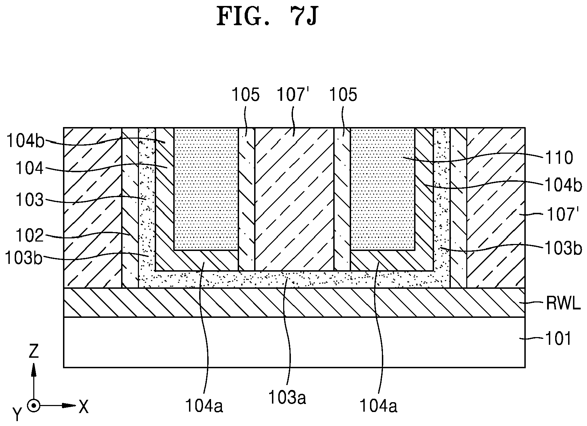

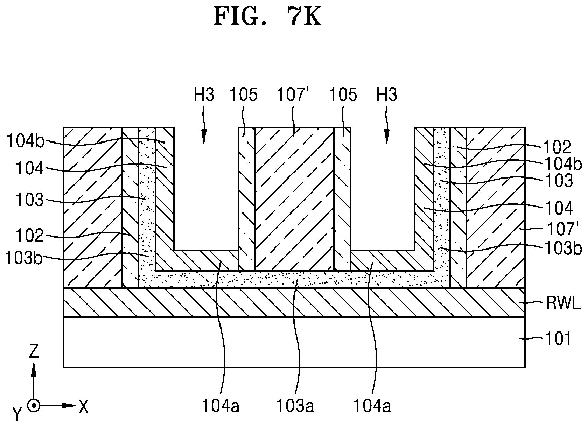

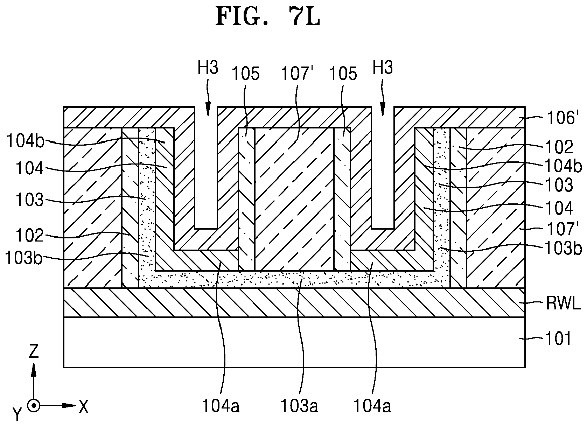

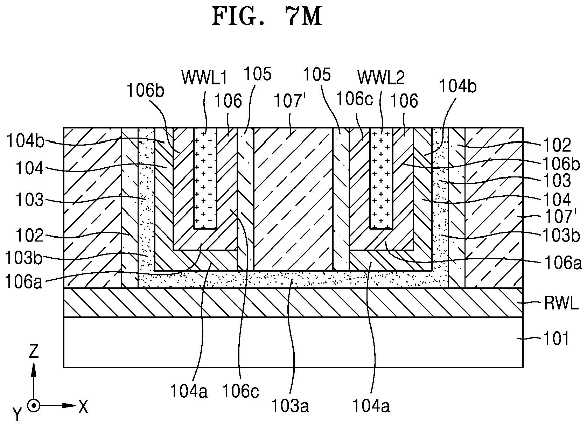

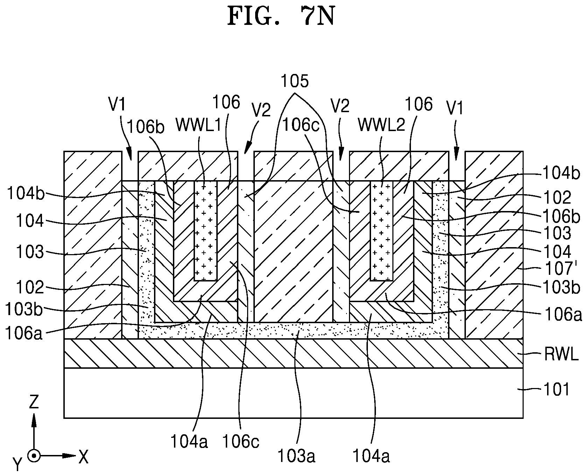

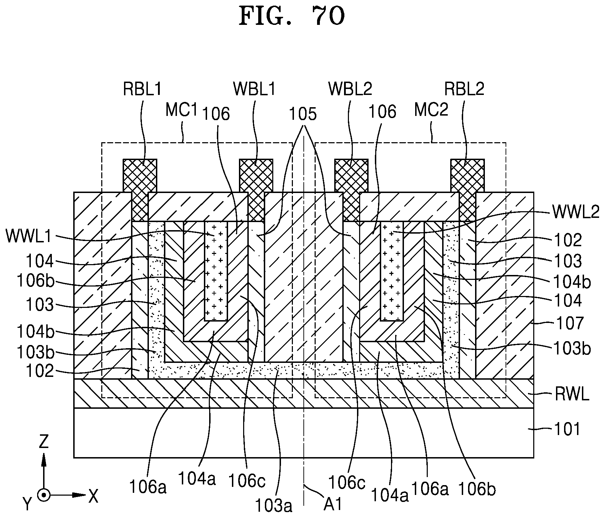

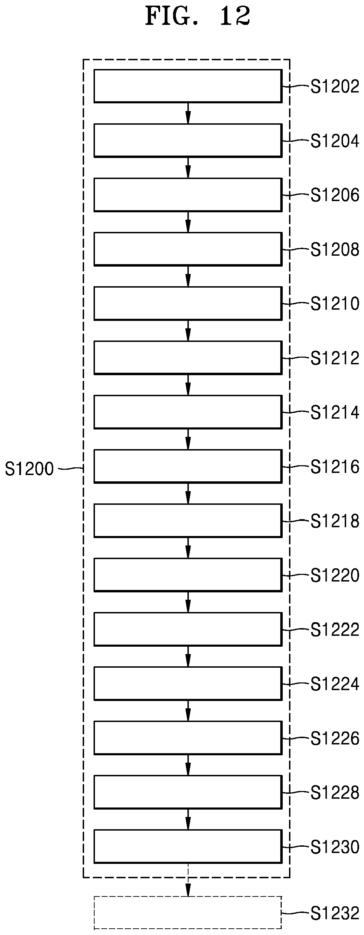

FIGS. 7A, 7B, 7C, 7D, 7E, 7F, 7G, 7H, 7I, 7J, 7K, 7L, 7M, 7N, and 7O are schematic cross-sectional views of a manufacturing process of the memory cell MC of the memory device illustrated in FIG. 1. FIG. 12 is a flowchart showing a method according to some example embodiments that includes a process S1200 of manufacturing the memory cell MC of the memory device illustrated in FIG. 1.

First, referring to FIG. 7A and FIG. 12, at S1202, the read word line RWL may be formed within the upper surface 101u of the substrate 101. For example, grooves may be formed by partially etching the upper surface 101u of the substrate 101, and a conductive metal material may be filled into the grooves. Examples of the conductive metal material may include at least one metal selected from among tungsten (W), cobalt (Co), nickel (Ni), iron (Fe), titanium (Ti), molybdenum (Mo), chromium (Cr), zirconium (Zr), hafnium (Hf), niobium (Nb), tantalum (Ta), silver (Ag), gold (Au), aluminum (Al), copper (Cu), antimony (Sb), vanadium (V), ruthenium (Ru), platinum (Pt), zinc (Zn), and magnesium (Mg), or a metal alloy thereof. Then, the upper surface 101u of the substrate 101 and the upper surface RWLu of the read word line RWL may be planarized through a planarization process. An insulation material 107' may be deposited to cover the upper surface 101u of the substrate 101 and the upper surface of the read word line RWL. The insulation material 107' may include various metal oxides or metal nitrides. For example, the insulation material 107' may include at least one material from among silicon nitride (SiN), silicon oxide (SiO₂), silicon oxynitride (SiON), aluminum nitride (AIN), aluminum oxide (Al₂O₃), aluminum oxynitride (AION), tantalum oxide (Ta₂O₅), and hafnium oxide (HfO₂).

Referring to FIG. 7B and FIG. 12, at S1204, a first hole H1 may be formed by partially etching the insulation material 107'. When etching the insulation material 107', the insulation material 107' may be completely penetrated such that the upper surface of the substrate 101 and the upper surface of the read word line RWL are exposed to the outside. Accordingly, the upper surface of the substrate 101 and the upper surface of the read word line RWL may become a bottom surface of the first hole H1. A horizontal cross-section of the first hole H1 may have, for example, a rectangular shape, but is not limited thereto. Then, a first channel material 102' may be deposited to a constant thickness. Thus, the first channel material 102' may be formed on an upper surface of the insulation material 107', an inner sidewall of the first hole H1, and the bottom surface of the first hole H1. The first channel material 102' may include, for example, at least one oxide semiconductor material selected from among ZIO, IGO, and IGZO.

Referring to FIG. 7C and FIG. 12, at S1206, except the first channel material 102' formed on two facing (e.g., opposing) sidewalls in the first hole H1, the remaining first channel material 102' may be removed through etching. For example, the first channel material 102' on the upper surface of the insulation material 107' and the bottom surface of the first hole H1 may be removed through etching. Accordingly, two first channels 102 that are disposed in parallel to each other and face each other may be formed, and the upper surface 101u of the substrate 101 and the upper surface RWLu of the read word line RWL may be exposed to the outside again between the two first channels 102. The two first channels 102 formed as described above may extend along a plane perpendicular to the upper surface of the substrate 101.

Referring to FIG. 7D and FIG. 12, at S1208, a first gate insulation layer material 103' may be deposited to a constant thickness. Accordingly, the first gate insulation layer material 103' may be formed on the upper surface of the insulation material 107', surfaces of the first channels 102, and the bottom surface of the first hole H1. For example, the first gate insulation layer material 103' may include at least one material from among silicon nitride (SiN), silicon oxide (SiO₂), silicon oxynitride (SiON), aluminum nitride (AIN), aluminum oxide (Al₂O₃), aluminum oxynitride (AION), tantalum oxide (Ta₂O₅), and hafnium oxide (HfO₂).

Referring to FIG. 7E and FIG. 12, at S1210, a gate electrode material 104' may be deposited to a constant thickness on the first gate insulation layer material 103'. The gate electrode material 104' may be formed on the entire surface of the first gate insulation layer material 103' along an upper surface of the first gate insulation layer material 103' outside the first hole H1 and a side surface and a bottom surface of the first gate insulation layer material 103' inside the first hole H1. The gate electrode material 104' may include a conductive metal or metal alloy.

Referring to FIG. 7F and FIG. 12, at S1212, a filling material 110 may be deposited to completely fill the first hole H1. The filling material 110 may be one of materials of the insulation material 107' described above. For example, the filling material 110 may include at least one material from among silicon nitride (SiN), silicon oxide (SiO₂), silicon oxynitride (SiON), aluminum nitride (AIN), aluminum oxide (Al₂O₃), aluminum oxynitride (AION), tantalum oxide (Ta₂O₅), and hafnium oxide (HfO₂). Then, a planarization process may be performed to expose the upper surface of the insulation material 107'. Accordingly, the first gate insulation layer material 103', the gate electrode material 104', and the filling material 110 on the upper surface of the insulation material 107' may be removed, and the first gate insulation layer material 103', the gate electrode material 104', and the filling material 110 may be present only inside the first hole H1.

Accordingly, the first gate insulation layer 103 is completed. The first gate insulation layer 103 may include two main body portions 103b disposed on facing surfaces of the two first channels 102 and one extension portion 103a extending between lower portions of the two main body portions 103b. The extension portion 103a may extend between the two main body portions 103b along the upper surface of the substrate 101 and the upper surface of the read word line RWL. Accordingly, the first gate insulation layer 103 may extend from a surface of one first channel 102 to a surface of the other first channel 102 through the upper surface of the substrate 101 and the upper surface of the read word line RWL. The two main body portions 103b of the first gate insulation layer 103 formed as above may extend along a plane perpendicular to the upper surface of the substrate 101, and the extension portion 103a may extend along a plane parallel to the upper surface of the substrate 101.

Referring to FIG. 7G and FIG. 12, at S1214, a portion of the filling material 110 and a portion of the gate electrode material 104' may be etched to expose the upper surface 103au of the extension portion 103a of the first gate insulation layer 103. In particular, a central region of the filling material 110 may be etched and a central region of a bottom surface of the gate electrode material 104' may be etched such that a central region of the upper surface 103au of the extension portion 103a is exposed. Accordingly, a second hole H2 penetrating the central regions of the filling material 110 and the gate electrode material 104' may be formed. The upper surface of the extension portion 103a of the first gate insulation layer 103 may become a bottom surface of the second hole H2.

In addition, as the gate electrode material 104' is cut into two parts, two gate electrodes 104 disposed on a surface of the first gate insulation layer 103 may be completed. The two gate electrodes 104 may each include a main body portion 104b disposed in contact with the two main body portions 103b of the gate insulation layer 103 and an extension portion 104a disposed on a portion of a surface of the extension portion 103a of the gate insulation layer 103. Thus, the two gate electrodes 104 may face each other and have a symmetrical shape such that the two gate electrodes 104 have mirror symmetry across a plane and/or axis of symmetry A1 that extends perpendicular to the X-direction (e.g., plane A1 may be a YZ plane).

Referring to FIG. 7H and FIG. 12, at S1216, a second channel material 105' may be deposited to a constant thickness. The second channel material 105' may be formed to a constant thickness along the upper surface of the insulation material 107', the upper surface of the first channel 102, the upper surface of the first gate insulation layer 103, the upper surface of the gate electrode 104, an upper surface of the filling material 110, an inner sidewall of the second hole H2, and the bottom surface of the second hole H2. The inner sidewall of the second hole H2 is a side surface of the filling material 110, and the bottom surface of the second hole H2 is a central region of the upper surface of the extension portion 103a of the first gate insulation layer 103. Accordingly, the central region of the extension portion 103a of the first gate insulation layer 103 is covered by the second channel material 105'.

Referring to FIG. 7I and FIG. 12, at S1218, except the second channel material 105' formed on two facing (e.g., opposing) sidewalls in the second hole H2, the remaining second channel material 105' may be removed through etching. For example, the second channel material 105' on the upper surface of the insulation material 107', the upper surface of the first channel 102, the upper surface of the first gate insulation layer 103, the upper surface of the gate electrode 104, the upper surface of the filling material 110, and the bottom surface of the second hole H2 may be removed through etching. Thus, two second channels 105 that face each other and are disposed in parallel to each other are formed, and the central region of the extension portion 103a of the first gate insulation layer 103 may be exposed to the outside again between the two second channels 105. The two second channels 105 formed as above may extend along a plane perpendicular to the upper surface of the substrate 101, on the upper surface of the extension portion 103a of the first gate insulation layer 103. In addition, lower side surfaces of the two second channels 105 may contact the corresponding extension portions 104a of the gate electrodes 104.

Referring to FIG. 7J and FIG. 12, at S1220, the second hole H2 may be filled with an insulation material 107'. For example, after depositing the insulation material 107' to fill the second hole H2, a planarization process may be performed to expose the upper surface of the insulation material 107', the upper surface of the first channel 102, the upper surface of the gate insulation layer 103, the upper surface of the gate electrode 104, the upper surface of the filling material 110, and the upper surface of the second channel 105. Accordingly, the insulation material 107' may be disposed between the two facing second channels 105.

Referring to FIG. 7K and FIG. 12, at S1222, the filling material 110 may be removed through etching. Accordingly, a third hole H3 may be formed between the gate electrode 104 and the second channel 105 corresponding to each other. An inner sidewall of the third hole H3 is a side surface of the main body portion 104b of the gate electrode 104 and the side surface of the second channel 105, and a bottom surface of the third hole H3 is the upper surface of the extension portion 104a of the gate electrode 104.

Referring to FIG. 7L and FIG. 12, at S1224, a second gate insulation layer material 106' may be deposited to a constant thickness. The second gate insulation layer material 106' may be formed to a constant thickness on the upper surface of the insulation material 107', the upper surface of the first channel 102, the upper surface of the first gate insulation layer 103, the upper surface of the gate electrode 104, the upper surface of the second channel 105, a side surface of the gate electrode 104, the side surface of the second channel 105, and the upper surface of the extension portion 104a of the gate electrode 104. The second gate insulation layer material 106' may be formed to a thickness that does not completely fill the third hole H3. Accordingly, there may be an empty space surrounded by the second gate insulation layer material 106' inside the third hole H3. For example, the second gate insulation layer material 106' may include at least one material from among silicon nitride (SiN), silicon oxide (SiO₂), silicon oxynitride (SiON), aluminum nitride (AIN), aluminum oxide (Al₂O₃), aluminum oxynitride (AION), tantalum oxide (Ta₂O₅), and hafnium oxide (HfOz).

Referring to FIG. 7M and FIG. 12, at S1226, a conductive metal or metal alloy may be filled in the empty space surrounded by the second gate insulation layer material 106', and then a planarization process may be performed. The planarization process may be performed to expose the upper surface of the insulation material 107', the upper surface of the first channel 102, the upper surface of the first gate insulation layer 103, the upper surface of the gate electrode 104, and the upper surface of the second channel 105. Accordingly, two second gate insulation layers 106 and two write word lines WWL1 and WWL2 respectively surrounded by corresponding one of the two second gate insulation layers 106 may be formed.

Referring to FIG. 7N and FIG. 12, at S1228, the insulation material 107' may be additionally deposited to entirely cover the upper surface of the insulation material 107', the upper surface of the first channel 102, the upper surface of the first gate insulation layer 103, the upper surface of the gate electrode 104, the upper surface of the second channel 105, the upper surface of the second gate insulation layer 106, and upper surfaces of the write word lines WWL1 and WWL2. Then, the insulation material 107' may be partially etched to form via holes for electrical connection. For example, two first via holes V1 and two second via holes V2 may be formed by etching the insulation material 107' such that the upper surfaces of the two first channels 102 and the upper surfaces of the two second channels 105 are exposed. The remaining insulation material 107' may become the passivation layer 107.

Referring to FIG. 7O and FIG. 12, at S1230, the first via holes V1 and the second via holes V2 may be filled with a conductive metal or metal alloy to form the read bit lines RBL1 and RBL2 and the write bit lines WBL1 and WBL2, respectively. Portions of each of the read bit lines RBL1 and RBL2 and the write bit lines WBL1 and WBL2 may be formed to extend over a portion of the upper surface of the passivation layer 107.

A memory device including a plurality of memory cells may be manufactured in the above-described manner. According to the above method, two adjacent memory cells may have a symmetrical shape. For example, a first memory cell MC1 and a second memory cell MC2 disposed adjacent to each other may have a mirror symmetric shape with respect to each other, such that the first memory cell MC1 and the second memory cell MC2 have mirror symmetry across a plane and/or axis of symmetry A1 that extends perpendicular to the X-direction (e.g., plane A1 may be a YZ plane). Also, the first memory cell MC1 and the second memory cell MC2 may share one first gate insulation layer 103. In particular, the extension portion 103a of the first gate insulation layer 103 may extend between the first channel 102 of the first memory cell MC1 and the first channel 102 of the second memory cell MC2.

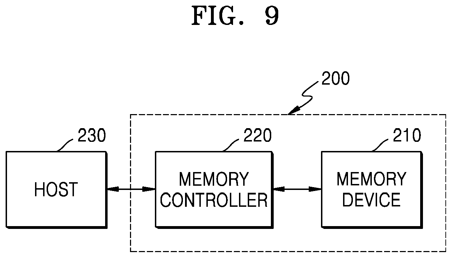

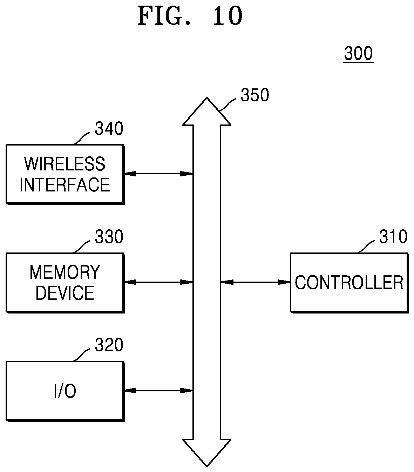

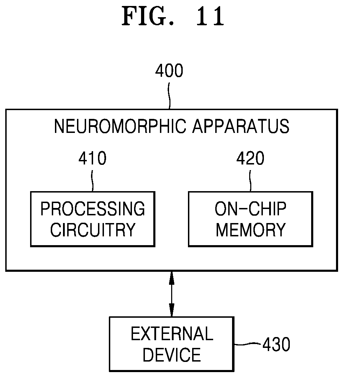

Still referring to FIG. 12, at S1232, one or more memory cells MC of a memory device manufactured at S1200 may be incorporated (e.g., applied) into the assembly of an electronic device, including for example an electronic device that includes a memory device. Such an electronic device may include, for example, the electronic system 200 shown in FIG. 9, the electronic system 300 shown in FIG. 10, the neuromorphic apparatus 400 shown in FIG. 11, or the like. For example, multiple memory cells MC of a memory device may be manufactured at S1200, and at S1232 the memory cells MC manufactured at S1200 may be included in a memory device (e.g., a DRAM device) which may be further incorporated into a manufactured electronic device, including for example the electronic system 200 shown in FIG. 9, the electronic system 300 shown in FIG. 10, the neuromorphic apparatus 400 shown in FIG. 11, or the like.

As a result, an electronic device configured to have improved integration and current leakage characteristics may be manufactured based on being manufactured to include one or more memory cells MC according to any of the example embodiments. Additionally, because the electronic device manufactured at S1232 includes one or more memory cells MC manufactured according to S1200, the process of manufacturing the electronic device as shown in FIG. 12 may have reduced complexity, and thus the costs of manufacturing the electronic device may be reduced and the risk of process defects in the electronic device due to complex manufacturing processes may be similarly reduced, based on the electronic device including one or more memory cells MC of the memory device as described herein, which may mitigate, reduce, or minimize the quantity of layers stacked on the substrate 101 in a direction perpendicular to the substrate 101 based on the memory cells MC including main components forming a read transistor TR1 and a write transistor TR2 that are arranged in parallel to each other in a direction perpendicular to the substrate 101 of the memory cell MC (e.g., in the Z-direction).

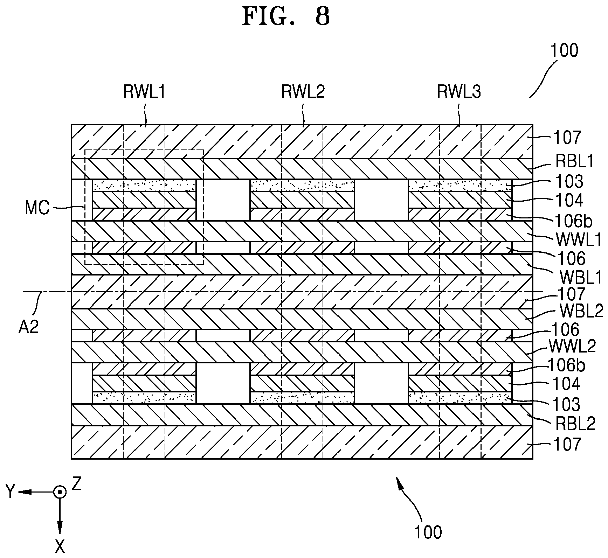

FIG. 8 is a schematic cross-sectional view of an arrangement of a plurality of memory cells of a memory device. In particular, FIG. 8 illustrates an example of a horizontal cross-section at the same location as the horizontal cross-section of the memory cell MC illustrated in FIG. 2. Referring to FIG. 8, a memory device 100 may include a plurality of memory cells MC that are two-dimensionally arranged along a plurality of rows and a plurality of columns. Also, the memory device 100 may include a plurality of read word lines RWL1, RWL2, RWL3, a plurality of read bit lines RBL1, RBL2, a plurality of write word lines WWL1 and WWL2, and a plurality of write bit lines WBL1 and WBL2 respectively connected to the plurality of memory cells MC. The plurality of read word lines RWL1, RWL2, and RWL3 may respectively extend in the first direction (X-direction) and be connected to the plurality of memory cells MC arranged in one column. Restated, the plurality of read word lines RWL1, RWL2, and RWL3 may be connected to separate, respective columns of memory cells MC. The plurality of read bit lines RBL1 and RBL2, the plurality of write word lines WWL1 and WWL2, and the plurality of write bit lines WBL1 and WBL2 may respectively extend in the second direction (Y-direction) perpendicular to the plurality of read word lines RWL1, RWL2 and RWL3 and be connected to the plurality of memory cells MC arranged in one row. Restated, each plurality of the plurality of read bit lines RBL1 and RBL2, the plurality of write word lines WWL1 and WWL2, and the plurality of write bit lines WBL1 and WBL2 may each be connected to separate, respective rows of memory cells MC.

Two memory cells adjacent each other in the first direction may have a mirror-symmetric shape with respect to each other, for example such that memory cells MC adjacent in the X-direction have mirror symmetry across a plane and/or axis of symmetry A2 that extends perpendicular to the X-direction (e.g., plane A2 may be a YZ plane). Accordingly, the plurality of read bit lines RBL1 and RBL2, the plurality of write word lines WWL1 and WWL2, and the plurality of write bit lines WBL1 and WBL2 respectively connected to two adjacent memory cells may be symmetrically arranged. For example, in a first row of the memory device 100, the read bit line RBL1, the write word line WWL1, and the write bit line WBL1 may be arranged in the order of the read bit line RBL1, the write word line WWL1, and the write bit line WBL1 along the first direction, and in a second row of the memory device 100, the write bit line WBL2, the write word line WWL2, and the read bit line RBL2 may be arranged in the order of the write bit line WBL2, the write word line WWL2, and the read bit line RBL2 along the first direction.

Each memory cell MC may have the structure illustrated in FIG. 1 or FIG. 7O. For example, each memory cell MC may include the first channel 102 electrically connected to one of the plurality of read word lines RWL1, RWL2, and RWL3 and one of the plurality of read bit lines RBL1 and RBL2, the second channel 105 electrically connected to one of the plurality of write bit lines WBL1 and WBL2, the first gate insulation layer 103 between the first channel 102 and the second channel 105, the second gate insulation layer 106 between the first gate insulation layer 103 and the second channel 105, and the gate electrode 104 between the first gate insulation layer 103 and the second gate insulation layer 106. One of the plurality of write word lines WWL1 and WWL2 may be disposed adjacent to the second gate insulation layer 106 between the first gate insulation layer 103 and the second gate insulation layer 106.

The memory device 100 described above may be applied to various electronic systems that store information or output and use stored information.

FIG. 9 is a schematic block diagram of an electronic system including a memory device. Referring to FIG. 9, an electronic system 200 includes a memory device 210 and a memory controller 220. The memory controller 220 may control the memory device 210 to read data from the memory device 210 and/or write data to the memory device 210, in response to a request by a host 230. The memory device 210 may include the memory device 100 according to any of the example embodiments described above.

FIG. 10 is a schematic block diagram of another electronic system including a memory device. Referring to FIG. 10, an electronic system 300 may configure a wireless communication device or a device capable of transmitting and/or receiving information in a wireless environment. The electronic system 300 includes a controller 310, an input/output device (I/O) 320, a memory device 330, and a wireless interface 340, which are respectively connected to one another through a bus 350.

The controller 310 may include at least one of a microprocessor, a digital signal processor, or a processing device similar thereto. The input/output device 320 may include at least one of a keypad, a keyboard, or a display. The memory device 330 may be used to store commands executed by the controller 310. For example, the memory device 330 may be used to store user data. The electronic system 300 may use the wireless interface 340 to transmit/receive data over a wireless communication network. The wireless interface 340 may include an antenna and/or a wireless transceiver. The memory device 330 may include the memory device 100 according to any of the example embodiments described above.

Also, the memory device 100 according to any of the example embodiments may be realized in the form of a chip and may be used as a neuromorphic computing platform. For example, FIG. 11 is a schematic diagram of a neuromorphic apparatus including a memory device, according to some example embodiments. Referring to FIG. 11, a neuromorphic apparatus 400 may include processing circuitry 410 and/or an on-chip memory 420. The on-chip memory 420 of the neuromorphic apparatus 400 may include the memory device 100 according to any of the example embodiments described above.

The processing circuitry 410 may be configured to control functions for driving the neuromorphic apparatus 400. For example, the processing circuitry 410 may be configured to control the neuromorphic apparatus 400 by executing programs stored in the on-chip memory 420 of the neuromorphic apparatus 400. The processing circuitry 410 may include hardware such as logic circuits; a hardware/software combination, such as a processor executing software; or a combination thereof. For example, a processor may include a central processing unit (CPU), a graphics processing unit (GPU), an application processor (AP) included in the neuromorphic apparatus 400, an arithmetic logic unit (ALU), a digital processor, a microcomputer, a field programmable gate array (FPGA), a system-on-chip (SoC), a programmable logic unit, a microprocessor, an application-specific integrated circuit (ASIC), or the like. Also, the processing circuitry 410 may be configured to read/write a variety of data from/in an external device 430 and/or execute the neuromorphic apparatus 400 by using the read/written data. The external device 430 may include an external memory and/or sensor array with an image sensor (e.g., a complementary metal oxide semiconductor (CMOS) image sensor circuit).

The neuromorphic apparatus 400 in FIG. 11 may be applied in a machine learning system. The machine learning system may utilize a variety of artificial neural network organizational and processing models, such as convolutional neural networks (CNN), de-convolutional neural networks, recurrent neural networks (RNN) optionally including long short-term memory (LSTM) units and/or gated recurrent units (GRU), stacked neural networks (SNN), state-space dynamic neural networks (SSDNN), deep belief networks (DBN), generative adversarial networks (GANs), and/or restricted Boltzmann machines (RBM).

Such machine learning systems may include other forms of machine learning models, such as, for example, linear and/or logistic regression, statistical clustering, Bayesian classification, decision trees, dimensionality reduction such as principal component analysis, and expert systems; and/or combinations thereof, including ensembles such as random forests. Such machine learning models may be used to provide various services, for example, an image classify service, a user authentication service based on bio-information or biometric data, an advanced driver assistance system (ADAS) service, a voice assistant service, an automatic speech recognition (ASR) service, or the like, and may be mounted in and executed by other electronic devices.

A memory device including the vertical channel transistor is described above according to some example embodiments as illustrated in the drawings. However, the descriptions are only examples, and one of ordinary skill in the art may understand that various modifications and equivalent embodiments are possible from the descriptions.

As described herein, any devices, systems units, modules, blocks, and/or portions thereof according to any of the example embodiments (e.g., the electronic system 200, the memory device 210, the memory controller 220, the host 230, the electronic system 300, the controller 310, the input/output device 320, the memory device 330, the wireless interface 340, the neuromorphic apparatus 400, the processing circuitry 410, the on-chip memory 420 any portion thereof, or the like) may include, may be included in, and/or may be implemented by one or more instances of circuitry such as hardware including logic circuits; a hardware/software combination such as processing circuitry executing software; or any combination thereof. For example, the circuitry more specifically may include, but is not limited to, a central processing unit (CPU), an arithmetic logic unit (ALU), a graphics processing unit (GPU), an application processor (AP), a digital signal processor (DSP), a microcomputer, a field programmable gate array (FPGA), and programmable logic unit, a microprocessor, application-specific integrated circuit (ASIC), a neural network processing unit (NPU), an Electronic Control Unit (ECU), an Image Signal Processor (ISP), and the like. In some example embodiments, the circuitry may include a non-transitory computer readable storage device (e.g., a memory), for example a DRAM device, storing a program of instructions, and a processor (e.g., CPU) configured to execute the program of instructions to implement the functionality and/or methods performed by some or all of any devices, systems units, modules, blocks, and/or portions thereof according to any of the example embodiments, and/or any portions thereof. For example, the memory controller 220 of the electronic system 200 may include a memory storing a program of instructions and circuitry configured to execute the program of instructions to cause the memory controller 220 to control the memory device 210 of the electronic system 200 to read data from the memory device 210 or write data to the memory device 210. In another example, the controller 310 of the electronic system 300 may include a memory storing a program of instructions and circuitry configured to execute the program of instructions to cause the controller 310 to control the memory device 330 of the electronic system 300 to read data from the memory device 330 or write data to the memory device 330.

It should be understood that some example embodiments described herein should be considered in a descriptive sense only and not for purposes of limitation. Descriptions of features or aspects within each example embodiment should typically be considered as available for other similar features or aspects in other embodiments. While some example embodiments have been described with reference to the figures, it will be understood by those of ordinary skill in the art that various changes in form and details may be made therein without departing from the scope as defined by the following claims.

## Claims

1. A memory device, comprising:
a substrate;
a read word line on the substrate;
a first channel electrically connected to the read word line and extending along a plane perpendicular to an upper surface of the substrate;
a second channel facing the first channel in parallel;
a first gate insulation layer adjacent to the first channel between the first channel and the second channel;
a second gate insulation layer adjacent to the second channel between the first channel and the second channel;
a gate electrode adjacent to the first gate insulation layer between the first gate insulation layer and the second gate insulation layer;
a write word line adjacent to the second gate insulation layer between the first gate insulation layer and the second gate insulation layer;
a read bit line electrically connected to the first channel; and
a write bit line electrically connected to the second channel.

2. The memory device of claim 1, wherein the first channel, the second channel, the first gate insulation layer, the second gate insulation layer, the gate electrode, and the write word line have a shape protruding in a direction perpendicular to the upper surface of the substrate.

3. The memory device of claim 1 or 2, wherein the read word line is on the substrate such that a lower surface and opposite side surfaces of the read word line are surrounded by the substrate, the read word line extending in a first direction parallel to the upper surface of the substrate.

4. The memory device of claim 3, wherein the first channel, the second channel, the read bit line, the first gate insulation layer, the gate electrode, the second gate insulation layer, the write word line, and the write bit line each extend in a second direction perpendicular to the first direction and parallel to the upper surface of the substrate.

5. The memory device of any preceding claim, wherein the first gate insulation layer comprises:
a main body portion extending in a direction perpendicular to the upper surface of the substrate; and
an extension portion extending from a lower portion of the main body portion of the first gate insulation layer in a separate direction parallel to the upper surface of the substrate.

6. The memory device of claim 5, wherein:
the main body portion of the first gate insulation layer is between the first channel and the gate electrode; and
the extension portion of the first gate insulation layer is between a lower surface of the second channel and the read word line, and optionally wherein:
the lower surface of the second channel is in contact with an upper surface of the extension portion of the first gate insulation layer; and
an upper surface of the second channel is electrically connected to the write bit line.

7. The memory device of claim 6, wherein the gate electrode comprises:
a main body portion extending in the direction perpendicular to the upper surface of the substrate; and
an extension portion extending from a lower portion of the main body portion of the gate electrode in the separate direction parallel to the upper surface of the substrate,
wherein the extension portion of the gate electrode is on the upper surface of the extension portion of the first gate insulation layer and contacts a lower side surface of the second channel.

8. The memory device of claim 7, wherein the second gate insulation layer comprises:
a main body portion extending in the direction perpendicular to the upper surface of the substrate;
a first extension portion extending from a lower portion of the main body portion of the second gate insulation layer in the separate direction parallel to the upper surface of the substrate; and
a second extension portion extending from the first extension portion and in the direction perpendicular to the upper surface of the substrate, and optionally wherein
the first extension portion of the second gate insulation layer is on an upper surface of the extension portion of the gate electrode, and
the second extension portion of the second gate insulation layer is in contact with the main body portion of the gate electrode.

9. The memory device of claim 8, wherein:
a first side surface of the write word line is in contact with the main body portion of the second gate insulation layer;
a lower surface of the write word line is in contact with the first extension portion of the second gate insulation layer; and
a second side surface of the write word line opposite the first side surface is in contact with the second extension portion of the second gate insulation layer.

10. The memory device of any preceding claim, wherein:
a lower surface of the first channel contacts the read word line; and
an upper surface of the first channel contacts the read bit line.

11. The memory device of any preceding claim, wherein:
the first channel, the first gate insulation layer, and the gate electrode collectively define a read transistor; and
the second channel, the second gate insulation layer, and the write word line collectively define a write transistor, and optionally wherein:
the first channel and the second channel each comprise an oxide semiconductor material; and
the read transistor and the write transistor each include a separate oxide semiconductor transistor.

12. A memory device, comprising:
a plurality of memory cells extending two-dimensionally in a plurality of rows and a plurality of columns;
a plurality of read word lines extending along a first direction and connected to separate, respective columns of memory cells of the plurality of memory cells;
a plurality of read bit lines extending along a second direction perpendicular to the first direction and connected to separate, respective rows of memory cells of the plurality of memory cells;
a plurality of write word lines extending along the second direction and connected to separate, respective rows of memory cells of the plurality of memory cells; and
a plurality of write bit lines extending along the second direction and connected to separate, respective rows of memory cells of the plurality of memory cells,
wherein each memory cell of the plurality of memory cells includes a memory device according to any preceding claim.

13. The memory device of claim 12, wherein:
the first channel is electrically connected to one read word line of the plurality of read word lines and one read bit line of the plurality of read bit lines;
the second channel is electrically connected to one write bit line of the plurality of write bit lines; and
one of the plurality of write word lines is adjacent to the second gate insulation layer between the first gate insulation layer and the second gate insulation layer.

14. The memory device of claim 12 or 13, wherein the plurality of memory cells includes a first memory cell and a second memory cell adjacent to each other in the first direction, wherein the first memory cell and the second memory cell have a mirror symmetry across a plane of symmetry that extends perpendicular to the first direction.

15. An electronic device comprising:
a memory device according to any of claims 1 to 11; and
a memory controller configured to control the memory device to read data from the memory device or write data to the memory device.
